# EUROPÄISCHE PATENTSCHRIFT

(11) **EP 2 487 543 B1**
(45) Veröffentlichungstag und Bekanntmachung des Hinweises auf die Patenterteilung: **26.06.2019**
(21) Anmeldenummer: 12152211.4
(22) Anmeldetag: 24.01.2012
(51) Int. Cl.: G03F 7/20

(54) **Beleuchtungsoptik für die Projektionslithographie**
Illumination lens for projection lithography
Optique d'éclairage pour lithographie de projection

(30) Priorität: 10.02.2011 DE 102011003928; 10.02.2011 US 201161441328 P
(43) Veröffentlichungstag der Anmeldung: 15.08.2012
(73) Patentinhaber: Carl Zeiss SMT GmbH, 73447 Oberkochen (DE)
(72) Erfinder: Wangler, Johannes, 89551 Königsbronn (DE); Degünther, Markus, 73432 Aalen (DE); Bieling, Stig, 73434 Aalen (DE)
(74) Vertreter: Rau, Schneck & Hübner Patentanwälte Rechtsanwälte PartGmbB

(56) Entgegenhaltungen:
- DE-A1-102007 041 004
- DE-A1-102008 049 556
- US-A1- 2005 088 760

## Beschreibung

Die Erfindung betrifft eine Beleuchtungsoptik für die Projektionslithographie zur Ausleuchtung eines Objektfeldes, in dem ein abzubildendes Objekt anordenbar ist, mit Beleuchtungslicht. Ferner betrifft die Erfindung ein Beleuchtungssystem mit einer derartigen Beleuchtungsoptik, eine Projektionsbelichtungsanlage mit einem derartigen Beleuchtungssystem, ein Herstellungsverfahren zur Herstellung eines mikro- bzw. nanostrukturierten Bauteils unter Einsatz einer solchen Projektionsbelichtungsanlage sowie ein mit einem solchen Herstellungsverfahren hergestelltes mikro- bzw. nanostrukturiertes Bauelement.

Eine Beleuchtungsoptik der eingangs genannten Art ist bekannt aus der WO 2010/049076 A2 und der WO 2009/095052 A1. Die DE 10 2007 041 004 A1 beschreibt eine Beleuchtungsoptik für die EUV-Mikrolithografie. Die US 2005/0 088 760 A1 beschreibt ein Beleuchtungssystem für die Mikrolithografie. Die DE 10 2008 049 556 A1 beschreibt eine mikrolithografische Projektionsbelichtungsanlage.

Es ist eine Aufgabe der vorliegenden Erfindung, die Beleuchtung des abzubildenden Objekts flexibel zu gestalten und an Vorgabewerte gut anpassbar zu machen.

Diese Aufgabe ist erfindungsgemäß gelöst durch eine Beleuchtungsoptik mit den im Anspruch 1 angegebenen Merkmalen.

Erfindungsgemäß wurde erkannt, dass ein vor dem Feldfacettenspiegel angeordnetes Einzelspiegelarray neue Freiheitsgrade bei der Auslegung der Objektfeldbeleuchtung liefert. Das Einzelspiegelarray kann als Multi- bzw. Mikrospiegel-Array und kann insbesondere als mikroelektromechanisches System (MEMS) ausgebildet sein. Die Facetten des Feldfacettenspiegels und/oder die Facetten des Pupillenfacettenspiegels können als starre, also als nicht zwischen verschiedenen Kippstellungen kippbare Facetten ausgebildet sein. Die Feldfacetten bilden die Einzelspiegel der Einzelspiegelarrays auf zugeordnete Pupillenfacetten ab. Die Feldfacetten des Feldfacettenspiegels können in nicht zusammenhängenden Facettenbereichen angeordnet sein, zwischen denen Zwischenräume vorliegen. Die einzelnen, voneinander getrennten Facettenbereiche können mit einer größeren Anzahl von Freiheitsgraden zueinander angeordnet sein. Eine nicht zusammenhängende Anordnung von Facettenbereichen kann besonders dann genutzt werden, wenn ein Strahlengang des Beleuchtungslichts vor dem Feldfacettenspiegel bereits in verschiedene Teilbündel aufgeteilt wird. Die Feldfacetten des Feldfacettenspiegels können in ihrer Gesamtheit so angeordnet sein, dass sie von den Einzelspiegeln des Einzelspiegelarrays mit Kippstellungen der Einzelspiegel mit geringen absoluten Kippwinkeln erreicht werden. Feldfacetten, die eine Gruppe von Einzelspiegeln auf verschiedene Pupillenfacetten abbilden, können so angeordnet sein, dass ein für die Einzelspiegel zum Erreichen einer derartigen Beleuchtungsgeometrie notwendiger Kippwinkel, damit das Beleuchtungslicht die gewünschten Feldfacetten erreicht, jeweils so schnell wie möglich erreicht ist.

Die Pupillenfacetten des Pupillenfacettenspiegels können in einer hexagonal dichtesten Packung, können in einer kartesischen Anordnung, also zeilen- und spaltenweise, oder können auch rotationssymmetrisch angeordnet sein. Die Anordnung der Pupillenfacetten kann, beispielsweise zur Korrektur von Verzeichnungseffekten, verzerrt sein.

Anordnungen nach den Ansprüchen 2 und 3 haben sich zur Erreichung einer Beleuchtungsflexibilität als besonders geeignet herausgestellt.

Eine Auslegung nach Anspruch 4 hat sich zur Korrektur einer Intensitätsverteilung über das Objektfeld (Uniformitäts- bzw. Uniformity-Korrektur) als gut geeignet herausgestellt. Eine Definition der Uniformität findet sich in der WO 2009/095052 A1.

Eine Auslegung nach Anspruch 5 erlaubt insbesondere die Einstellung einer vom Ort auf dem Objektfeld abhängigen Beleuchtungswinkelverteilung einer Beleuchtung des Objekts. Dies kann für anspruchsvolle Abbildungsanforderungen genutzt werden.

Auslegungen des Beleuchtungsstrahlengangs nach den Ansprüchen 6 oder 7 haben sich als besonders geeignet für die Zuordnung der Einzelspiegel des Einzelspiegelarrays zu den Feldfacetten herausgestellt. Über derartige Auslegungen lässt sich eine Abhängigkeit eines Intensitätsverlaufes einer Intensität des Beleuchtungslichts längs einer vorgegebenen Richtung, beispielsweise senkrecht zu einer Verlagerungsrichtung des bei der Projektionsbelichtung abzubildenden Objektes vorgeben. Dies kann zur Korrektur des Intensitätsverlaufs genutzt werden.

Einfallswinkel nach Anspruch 8 (streifender Einfall) ermöglichen eine Reflexion am Einzelspiegelarray mit besonders geringen Beleuchtungslichtverlusten. Die Anordnung kann derart sein, dass die Einzelspiegel unter einem Einfallswinkel beleuchtet werden, der größer ist als 65° oder größer als 70 ° ist. Alternativ kann die Beleuchtungsoptik so angeordnet sein, dass die Einzelspiegel unter einem Einfallswinkel beleuchtet werden, der im Bereich der senkrechten Inzidenz liegt.

Eine Anbringung der Einzelspiegel auf einer gewölbten Grundplatte nach Anspruch 9 führt zur Möglichkeit, die Einzelspiegel so anzuordnen, dass sie ein auf das Einzelspiegelarray divergent auftreffendes Strahlungsbündel mit gleichen Einfallswinkeln reflektieren. Die Wölbung kann so gewählt werden, dass bei Einstellen der Einzelspiegel in der Neutralposition eine vom Einzelspiegelarray reflektierte Form des EUV-Strahlungsbündels resultiert, die einer gewünschten Bündelform entspricht. Diese Form kann insbesondere der Gestalt der Anordnung der Gesamtheit der Feldfacetten des Feldfacettenspiegels entsprechen. Auch ein gewünschter Intensitätsverlauf innerhalb des EUV-Strahlungsbündels nach Reflexion am Einzelspiegelarray kann durch eine entsprechende Wölbung der Grundplatte des Einzelspiegelarrays erreicht werden. Alternativ kann das Einzelspiegelarray eine plane Grundplatte haben.

Eine Auslegung eines ansteuerbaren Kippbereichs nach Anspruch 10 ermöglicht, ausgehend von der Neutralstellung, ein Verkippen der Einzelspiegel über einen weiten Kippbereich in einer Vorzugs-Kipprichtung. Dieser Kippbereich kann beispielsweise einen Kippwinkel von 20 ° überstreichen.

Eine Unterteilung des Einzelspiegelarrays nach Anspruch 11 ermöglicht die Reflexion eines EUV-Strahlungsbündels mit großem Divergenzwinkel, also mit großer numerischer Apertur. Das Einzelspiegelarray kann in zwei Abschnitte unterteilt sein. Auch eine größere Anzahl derartiger Abschnitte ist möglich. Das in Abschnitte unterteilte Einzelspiegelarray kann einen genesteten Aufbau haben, wie dieser beispielsweise bei Wolter-Optiken bekannt ist und besonders bei EUV-Kollektoren in der EUV-Projektionslithographie zum Einsatz kommt.

Eine Zuordnung von Pupillenfacettenbereichen zu Feldfacettenbereichen nach Anspruch 12 ermöglicht eine Optimierung der Systemeffizienz bzw. der Reflexionseffizienz der Beleuchtungsoptik und damit eine Optimierung des Nutzlicht-Durchsatzes. Die zusammenhängenden Pupillenfacettenbereiche können so gewählt werden, dass vorgegebene Beleuchtungssettings, beispielsweise polare Beleuchtungssettings wie Dipol-, Multipol-Beleuchtungssettings, annulare Beleuchtungssettings oder konventionelle Beleuchtungssettings mit vorgegebenem maximalem Beleuchtungswinkel, hieraus zusammengesetzt werden können. Derartige Beleuchtungssettings sind beispielsweise aus der WO 2009/095 052 A1 bekannt. Die zusammenhängenden Pupillenfacettenbereiche können so gewählt werden, dass Beleuchtungssettings mit möglichst hoher Energieeffizienz, also mit möglichst gutem Beleuchtungslicht-Durchsatz der Beleuchtungsoptik, vorgegeben werden können.

Die zusammenhängenden Pupillenfacettenbereiche können als Sektoren auf dem Pupillenfacettenspiegel ausgeführt sein. Die zusammenhängenden Feldfacettenbereiche können als Spalten eines Feldfacettenspiegels mit zeilen- und spaltenweiser Anordnung der Feldfacetten ausgeführt sein. Eine Feldfacetten-Zeilenposition in einem Feldfacettenspiegel mit so angeordneten zusammenhängenden Feldfacettenbereichen kann ein Maß für eine radiale Position der zugeordneten Pupillenfacette des Pupillenfacettenbereichs sein.

Die Vorteile eines Beleuchtungssystems nach Anspruch 13, einer Projektionsbelichtungsanlage nach Anspruch 14, eines Herstellungsverfahrens nach Anspruch 15 und eines mikro- bzw. nanostrukturierten Bauteils entsprechen denen, die vorstehende Bezugnahme auf die erfindungsgemäße Optik bereits erläutert wurden. Als Strahlungsquelle für die Projektionsbelichtungsanlage kann eine EUV-Strahlungsquelle zum Einsatz kommen.

Ausführungsbeispiele der Erfindung werden nachfolgend anhand der Zeichnung näher erläutert. In dieser zeigen:
- Fig. 1: stark schematisch eine Projektionsbelichtungsanlage für die Mikrolithographie mit einer im Meridionalschnitt dargestellten Beleuchtungsoptik und einer Projektionsoptik;
- Fig. 2: schematisch und aus Darstellungsgründen in Transmission Abbildungsverhältnisse zwischen einem Abschnitt eines Einzelspiegelarrays, zugeordneten Feldfacetten eines Feldfacettenspiegels und zugeordneten Pupillenfacetten eines Pupillenfacettenspiegels der Beleuchtungsoptik nach Fig. 1 für zwei unterschiedliche, über eine entsprechende Verkippung von Einzelspiegeln des Einzelspiegelarrays einstellbare Beleuchtungssituationen;
- Fig. 3: schematisch eine Ausleuchtung einer der Feldfacetten des Feldfacettenspiegels bei einer ersten der Beleuchtungssituationen nach Fig. 2;
- Fig. 4: eine Ausleuchtung einer der Pupillenfacetten bei der ersten Beleuchtungssituation nach Fig. 2;
- Fig. 5: eine Ausleuchtung der zugeordneten Feldfacetten in einer zweiten Beleuchtungssituation, in der Teilbündel der Beleuchtung so groß sind, dass sie abschnittsweise von mehreren benachbarten Feldfacetten reflektiert werden;
- Fig. 6: eine Ausleuchtung der Pupillenfacetten bei der Beleuchtungssituation nach Fig. 5;
- Fig. 7: Details einer Beleuchtung des Einzelspiegelarrays mit einem EUV-Strahlungsbündel;
- Fig. 8: einen Ausschnitt des Einzelspiegelarrays mit insgesamt 6 Einzelspiegeln, die mit EUV-Strahlen beaufschlagt sind;
- Fig. 9 bis 11: jeweils einen Ausschnitt des Einzelspiegelarrays mit drei Einzelspiegeln, dargestellt in jeweils einer anderen Kippstellung;
- Fig. 12: in einer zur Fig. 7 ähnlichen Darstellung eine weitere Ausführung eines Einzelspiegelarrays, unterteilt in mehrere separate Array-Abschnitte;
- Fig. 13: beispielhaft in einer zu den Fig. 3 und 5 ähnlichen Darstellung wiederum eine Ausleuchtung zweier Zweiergruppen von Feldfacetten mit Einzelspiegel-Gruppen und einer nachfolgenden Abbildung der Einzelspiegel-Gruppen auf zugeordnete Pupillenfacetten, zusammen mit einer den beleuchteten Pupillenfacetten zugeordneten Intensitätsverteilung in einer Objektebene quer zu einer Verlagerungsrichtung eines bei der Projektionsbelichtung abzubildenden Objekts;
- Fig. 14: eine Aufsicht auf einen Ausschnitt des Einzelspiegelarrays;
- Fig. 15: schematisch eine Aufsicht auf einen Pupillenfacettenspiegel mit einer Unterteilung in zusammenhängende Pupillenfacettenbereiche; und
- Fig. 16: schematisch eine Aufsicht auf einen Feldfacettenspiegel mit, zugeordnet zu den Pupillenfacettenbereichen des Pupillenfacettenspiegels nach Fig. 15, in zusammenhängenden Feldfacettenbereichen angeordneten Feldfacetten.

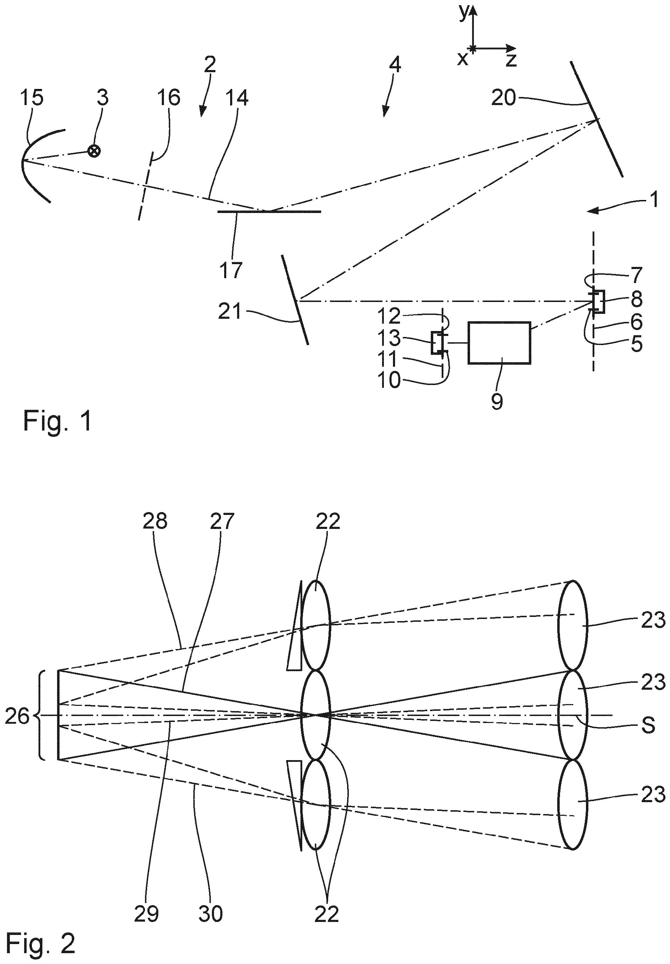

Fig. 1 zeigt stark schematisch in einem Meridionalschnitt eine Projektionsbelichtungsanlage 1 für die Mikrolithografie. Ein Beleuchtungssystem 2 der Projektionsbelichtungsanlage 1 hat neben einer Strahlungsquelle 3 eine Beleuchtungsoptik 4 zur Belichtung eines Objektfeldes 5 in einer Objektebene 6.

Zur Vereinfachung einer Erläuterung von Lagebeziehungen wird nachfolgend in der Zeichnung ein kartesisches xyz-Koordinatensystem verwendet. Eine x-Achse verläuft senkrecht zur Zeichenebene der Fig. 1 in diese hinein. Eine y-Achse verläuft in der Fig. 1 nach oben. Eine z-Achse verläuft in der Fig. 1 nach rechts. Die z-Achse verläuft senkrecht zur Objektebene 6.

In ausgewählten der nachfolgenden Figuren ist ein lokales kartesisches xyz-Koordinatensystem eingezeichnet, wobei die x-Achse parallel zur x-Achse nach der Fig. 1 verläuft und die y-Achse mit dieser x-Achse die optische Fläche des jeweiligen optischen Elements aufspannt. Teilweise wird die optische Fläche des jeweiligen optischen Elements auch parallel zur xz-Ebene aufgespannt.

Das Objektfeld 5 kann rechteckig oder bogenförmig mit einem x/y-Aspektverhältnis von beispielsweise 13/1 gestaltet sein. Belichtet wird hierbei ein im Objektfeld 5 angeordnetes reflektierendes Retikel 7, das eine mit der Projektionsbelichtungsanlage 1 zur Herstellung mikro- bzw. nanostrukturierter Halbleiter-Bauelemente zu projizierende Struktur trägt. Das Retikel 7 wird von einem Retikelhalter 8 getragen, der angetrieben in der y-Richtung verlagerbar ist. Eine Projektionsoptik 9 dient zur Abbildung des Objektfeldes 5 in ein Bildfeld 10 in einer Bildebene 11. Abgebildet wird die Struktur auf dem Retikel 7 auf eine lichtempfindliche Schicht eines im Bereich des Bildfeldes 10 in der Bildebene 11 angeordneten Wafers 12. Der Wafer 12 wird von einem Waferhalter 13 getragen, der bei der Projektionsbelichtung synchron zum Retikelhalter 8 in der y-Richtung angetrieben verlagert wird.

Das Retikel 7 und der Wafer 12 werden beim Betrieb der Projektionsbelichtungsanlage 1 synchron in der y-Richtung gescannt. Abhängig vom Abbildungsmaßstab der Projektionsoptik 9 kann auch ein gegenläufiges Scannen des Retikels 7 relativ zum Wafer 12 stattfinden.

Bei der Strahlungsquelle 3 handelt es sich um eine EUV-Strahlungsquelle mit einer emittierten Nutzstrahlung im Bereich zwischen 5 nm und 30 nm. Es kann sich dabei um eine Plasmaquelle, beispielsweise um eine GDPP-Quelle (Plasmaerzeugung durch Gasentladung, Gas Discharge Produced Plasma), oder um eine LPP-Quelle (Plasmaerzeugung durch Laser, Laser Produced Plasma) handeln. Auch andere EUV-Strahlungsquellen, beispielsweise solche, die auf einem Synchrotron oder auf einem Free Electron Laser (Freie Elektronenlaser, FEL) basieren, sind möglich.

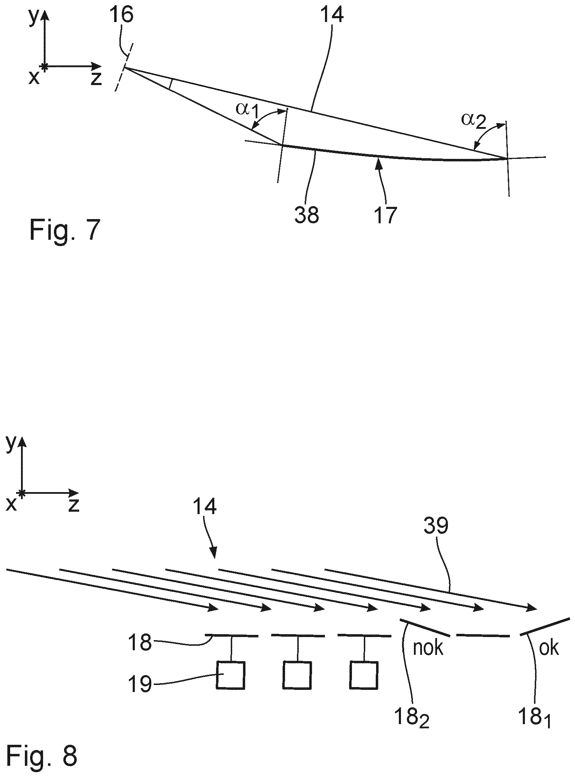

Ein EUV-Strahlungsbündel 14, das von der Strahlungsquelle 3 ausgeht, und in der Fig. 1 durch einen strichpunktierten Hauptstrahl angedeutet ist, wird von einem Kollektor 15 gebündelt. Ein entsprechender Kollektor ist beispielsweise aus der EP 1 225 481 A bekannt. Nach dem Kollektor 15 propagiert das EUV-Strahlungsbündel 14 durch eine Zwischenfokusebene 16, bevor sie auf ein Einzelspiegelarray 17 trifft. Bei ebenfalls möglichen Varianten der Führung des EUV-Strahlungsbündels 14 liegt ein Zwischenfokus vor oder es liegen mehrere Zwischenfokusse vor. Das Einzelspiegelarray 17 ist als mikroelektromechanisches System (MEMS) ausgebildet. Es weist eine Vielzahl von matrixartig zeilen- und spaltenweise in einem Array angeordneten Einzelspiegeln 18 auf, die schematisch in den Fig. 8 bis 11 dargestellt sind. Die Einzelspiegel 18 können quadratische oder rechteckige Reflexionsflächen haben. Diese Reflexionsflächen liegen angenähert in einer Ebene, die zur xz-Ebene des globalen xyz-Koordinatensystems nach Fig. 1 verläuft. Die Einzelspiegel 18 sind jeweils mit Aktoren 19 verbunden und um zwei in der Reflexionsebene des jeweiligen Einzelspiegels 18 senkrecht aufeinander stehende Achsen verkippbar ausgelegt. Insgesamt weist das Einzelspiegelarray 17 etwa 100.000 der Einzelspiegel 18 auf. Je nach Größe der Einzelspiegel 18 kann der Einzelspiegelarray auch beispielsweise 1.000, 5.000, 7.000 oder auch mehrere hunderttausend, beispielsweise 500.000 Einzelspiegel 18 aufweisen. Die Einzelspiegel 18 können eine hoch reflektierende Mehrfachschicht aufweisen, die für den jeweiligen Einfallswinkel und die Wellenlänge des EUV-Nutzlichts optimiert ist.

Vor dem Einzelspiegelarray 17 kann ein Spektralfilter angeordnet sein, der das genutzte EUV-Strahlungsbündel 14 von anderen, nicht für die Projektionsbelichtung nutzbaren Wellenlängenkomponenten der Emission der Strahlungsquelle 3 trennt. Der Spektralfilter ist nicht dargestellt. Nach dem Einzelspiegelarray 17 trifft das EUV-Strahlungsbündel 14 auf einen Feldfacettenspiegel 20. Der Feldfacettenspiegel 20 ist in einer Ebene der Beleuchtungsoptik 4 angeordnet, die zur Objektebene 6 optisch konjugiert ist. Das EUV-Strahlungsbündel 14 wird nachfolgend auch als Nutzstrahlung, Beleuchtungslicht oder als Abbildungslicht bezeichnet.

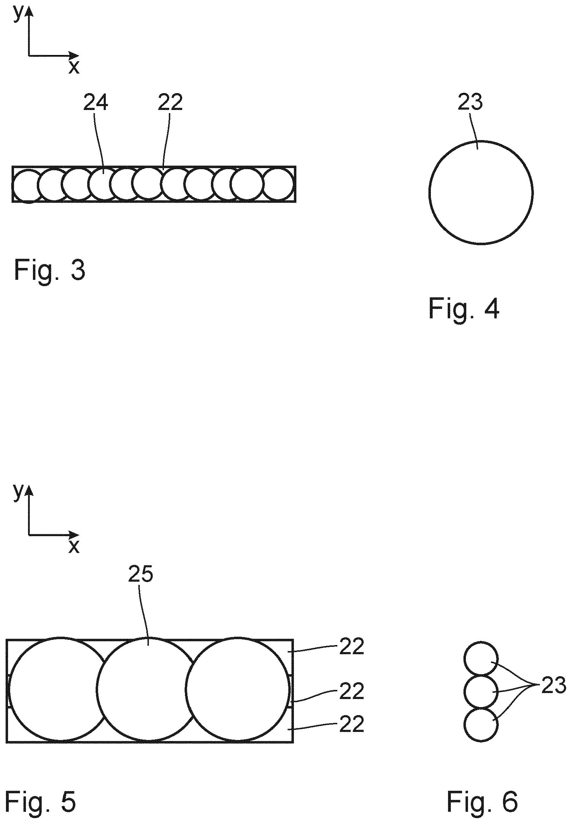

Nach dem Feldfacettenspiegel 20 wird das EUV-Strahlungsbündel 14 von einem Pupillenfacettenspiegel 21 reflektiert. Der Pupillenfacettenspiegel 21 liegt entweder in der Eintrittspupillenebene der Beleuchtungsoptik 4 oder in einer hierzu optisch konjugierten Ebene. Der Feldfacettenspiegel 20 und der Pupillenfacettenspiegel 21 sind jeweils aus einer Vielzahl von Facetten aufgebaut, die auch als Waben bezeichnet werden und nachfolgend noch näher beschrieben werden. Dabei kann die Unterteilung des Feldfacettenspiegels 20 derart sein, dass jede der Feldfacetten 22 (vgl. Fig. 3, 5 und 13), die für sich das gesamte Objektfeld 5 ausleuchten, durch genau einen einzelnen Spiegel repräsentiert wird. Alternativ ist es möglich, zumindest einige oder alle der Feldfacetten durch eine Mehrzahl von Spiegeln aufzubauen. Entsprechendes gilt für die Ausgestaltung der den Feldfacetten jeweils zugeordneten Pupillenfacetten 23 (vgl. Fig. 4, 6 und 13) des Pupillenfacettenspiegels, die jeweils durch einen einzelnen Spiegel oder durch eine Mehrzahl von Spiegeln gebildet sein können.

Das EUV-Strahlungsbündel 14 trifft auf das Einzelspiegelarray 17 unter einem Einfallswinkel auf, der größer ist als 70 ° (streifender Einfall, grazing incidence) und größer sein kann als 75 °, und trifft auf die beiden Facettenspiegel 20, 21 unter einem Einfallswinkel auf, der kleiner oder gleich 25 ° ist. Die beiden Facettenspiegel werden also im Bereich eines normal incidence-Betriebs mit der EUV-Strahlung 10 beaufschlagt. Auch eine Beaufschlagung unter streifendem Einfall (grazing incidence) ist möglich. Der Pupillenfacettenspiegel 21 ist in einer Ebene der Beleuchtungsoptik 4 angeordnet, die eine Pupillenebene der Projektionsoptik 9 darstellt bzw. zu einer Pupillenebene der Projektionsoptik 9 optisch konjugiert ist. Mithilfe des Pupillenfacettenspiegels 21 und ggf. einer in der Zeichnung nicht dargestellten nachfolgenden abbildenden optischen Baugruppe in Form einer Übertragungsoptik werden die Feldfacetten 22 des Feldfacettenspiegels 20 einander überlagernd in das Objektfeld 5 abgebildet.

Das Einzelspiegelarray 17 ist im Strahlengang des EUV-Strahlungsbündels 14, also in einem Beleuchtungslicht-Strahlengang, vor dem Feldfacettenspiegel 20 angeordnet.

Die Feldfacetten 22 des Feldfacettenspiegels 20 bilden das Einzelspiegelarray 17 abschnittsweise auf den Pupillenfacettenspiegel 21 ab. Dabei sind verschiedene Beleuchtungssituationen möglich, die nachfolgend anhand der Fig. 3 bis 6 und 13 erläutert werden.

In der Beleuchtungssituation nach den Figuren 3 und 4 fallen Einzelspiegel-Teilbündel 24 des EUV-Strahlungsbündels 14, die von Individuellen der Einzelspiegel 18 des Einzelspiegelarrays 17 reflektiert werden, auf genau eine der Feldfacetten 22.

Fig. 3 zeigt die Aufsicht auf genau eine der Feldfacetten 22. Die Feldfacetten 22 des Feldfacettenspiegels 20 haben ein x/y-Aspektverhältnis, welches dem x/y-Aspektverhältnis des Objektfeldes 5 entspricht. Die Feldfacetten 22 haben also ein x/y-Aspektverhältnis, das größer ist als 1. Eine lange Facettenseite der Feldfacetten 22 verläuft in der x-Richtung. Eine kurze Facettenseite der Feldfacetten 22 verläuft in der y-Richtung.

Insgesamt wird die Feldfacette 22 bei der Beleuchtungssituation nach Fig. 3 von elf Einzelspiegel-Teilbündeln 24 beaufschlagt. Die Einzelspiegel-Teilbündel 24 beaufschlagen die Feldfacette 22 in einer längs der x-Achse aufgereihten Reihe, wobei die Einzelspiegel-Teilbündel in der x-Richtung einander teilsweise überlappen, sodass die Feldfacette 22 in der x-Richtung zusammenhängend mit EUV-Licht beaufschlagt ist. Die Einzelspiegel-Teilbündel 24 haben einen Durchmesser, der in etwa der y-Erstreckung der Feldfacette 22 entspricht. Auch eine größere Anzahl der Einzelspiegel-Teilbündel 24, die die Feldfacette 22 einander überlappend der Reihe nach beaufschlagen, beispielsweise 15 Einzelspiegel-Teilbündel 24, 20 Einzelspiegel-Teilbündel 24, 25 Einzelspiegel-Teilbündel 24 oder eine noch größere Anzahl der Einzelspiegel-Teilbündel 24 ist möglich.

Die Feldfacette 22 nach Fig. 3 bildet die Einzelspiegel 18, von denen die Einzelspiegel-Teilbündel 24, die die Feldfacette 22 beaufschlagen, ausgehen, auf die in der Fig. 4 dargestellte Pupillenfacette 23 nebeneinander ab. Ein Ausschnitt des Einzelspiegelarrays 17 wird über die Feldfacette 22 auf die zugeordnete Pupillenfacette 23 abgebildet. Die Bilder der Einzelspiegel 18 überlappen auf der Pupillenfacette 23 nicht, sondern sind nebeneinander angeordnet. Der Ort der Pupillenfacette 23 auf dem Pupillenfacettenspiegel 21 gibt eine Beleuchtungsrichtung bzw. einen Beleuchtungswinkel für die Beleuchtung des Retikels 7 vor.

Bei der Beleuchtungssituation nach den Fig. 3 und 4 wird also eine Gruppe von beispielsweise elf Einzelspiegeln 18 des Einzelspiegelarrays 17 auf genau eine Pupillenfacette 23 abgebildet. In einer solchen Gruppe von Einzelspiegeln 18, die auf eine einzige Pupillenfacette 23 abgebildet werden, können auch andere Anzahlen von Einzelspiegeln vorhanden sein, beispielsweise zwei bis 50 Einzelspiegel mit zugehörigen Einzelspiegel-Teilbündeln 24.

Bei der Beleuchtungssituation nach den Fig. 5 und 6 haben Einzelspiegel-Teilbündel 25 eine y-Erstreckung, die etwa 3 mal so groß ist wie die y-Erstreckung der Feldfacetten 22. Jeweils eines der Einzelspiegel-Teilbündel 25 kann also in der y-Richtung drei benachbarte Feldfacetten 22 überdecken.

Die drei Feldfacetten 22 bilden die Einzelspiegel, die die Einzelspiegel-Teilbündel 25 reflektieren, in drei übereinander liegende Pupillenfacetten 23 ab, die in der Fig. 6 dargestellt sind.

Bei den Beleuchtungssituationen nach den Fig. 3 und 5 überlappen die Einzelspiegel-Teilbündel 24, 25, also Ausleuchtungsspots individueller Einzelspiegel 18, auf dem Feldfacettenspiegel 20.

Fig. 2 zeigt mit durchgezogenem Strahlengang eine Beleuchtungssituation, die derjenigen nach den Fig. 3 und 4 entspricht. Die Fig. 2 zeigt die Abbildungsverhältnisse zur besseren Verständlichkeit in Transmission. Von einem Abschnitt des Einzelspiegelarrays 17 mit einer Gruppe 26 von in der Fig. 2 nicht einzeln dargestellten Einzelspiegeln 18 geht ein Einzelspiegel-Gruppenbündel 27 aus, das von der in Fig. 2 mittleren Feldfacette 22 auf die in der Fig. 2 mittlere Pupillenfacette 23 abgebildet wird. Das Einzelspiegel-Gruppenbündel 27 kann als Zusammenfassung der Einzelspiegel-Teilbündel 24 nach Fig. 3 verstanden werden.

In der Fig. 2 gestrichelt ist die Situation dargestellt, wobei durch aktorische Verkippung der Einzelspiegel 18 der Gruppe 26 das von dieser Gruppe ausgehende Licht in drei Einzelspiegel-Untergruppenbündel 28, 29, 30 aufgeteilt wird, die drei einander benachbarte Feldfacetten 22 des Feldfacettenspiegels 20 beaufschlagen.

Das mittlere Einzelspiegel-Untergruppenbündel 29 hat dabei den gleichen Weg wie bei der zuerst mit der im Zusammenhang mit der Fig. 2 erläuterten Beleuchtungssituation. Die zugehörigen Einzelspiegel 18 mussten also nicht umgestellt werden. Dieses Einzelspiegel-Untergruppenbündel 29 wird also von der in der Fig. 2 mittleren Feldfacette 22 wiederum auf die in der Fig. 2 mittlere Pupillenfacette 23 abgebildet. Das in der Fig. 2 obere Einzelspiegel-Untergruppenbündel 28 wird von der in der Fig. 2 oben dargestellten Feldfacette 22 auf die in der Fig. 2 oben dargestellte Pupillenfacette 23 abgebildet. Eine Keilwirkung dieser oberen Feldfacette 22 ist in der Fig. 2 durch einen Keil angedeutet. Es handelt sich hierbei nicht um einen realen, optischen Keil, sondern lediglich um eine Veranschaulichung der Keilwirkung, die dazu führt, dass die in der Fig. 2 obere Pupillenfacette 23 von den oberen Einzelspiegel-Untergruppenbündeln 28 nicht zentrisch, sondern im in der Fig. 2 oberen Abschnitt beaufschlagt wird. Spiegelsymmetrisch zum Einzelspiegel-Untergruppenbündel 28 verläuft um eine senkrecht zur Zeichenebene der Fig. 2 verlaufende Symmetrieebene S das Einzelspiegel-Untergruppenbündel 30. Auch die entsprechend gegenläufige Keilwirkung der in der Fig. 2 unteren Feldfacette 22 ist wiederum durch einen Keil angedeutet.

Bei der Beleuchtungssituation nach Fig. 2 liegt also eine Anordnung derart vor, dass die Gruppe 26 mit mehreren Einzelspiegeln 18, die insgesamt auf eine der Pupillenfacetten 23, nämlich die in der Fig. 2 mittlere Pupillenfacette 23 abbildbar ist, durch entsprechende Verkippung von zumindest einigen der Einzelspiegeln 18 der Gruppe 26 auf eine Mehrzahl von Pupillenfacetten 23, nämlich die drei in der Fig. 2 dargestellten Pupillenfacette 23, abgebildet wird.

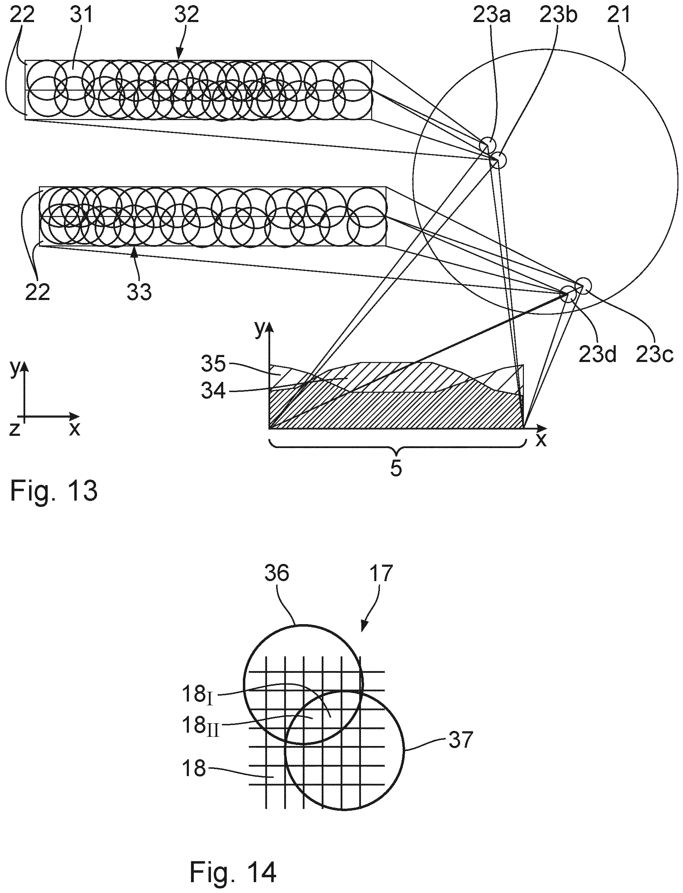

Fig. 13 zeigt eine weitere Beleuchtungssituation, bei der Einzelspiegel-Teilbündel 31 eine y-Erstreckung haben, die etwa das 1,3-fache einer y-Erstreckung der Feldfacetten 22 des Feldfacettenspiegels 20 haben. Zwei jeweils übereinander liegende und auf diese Weise zu einem Feldfacettenblock zusammengefasste Blöcke 32, 33 der Feldfacetten 22 werden von zwei Reihen der Einzelspiegel-Teilbündel 31 ausgeleuchtet, wobei sich die Einzelspiegel-Teilbündel sowohl in der x-Richtung als auch der y-Richtung überlappen. Die beiden jeweils zu einem Block 32, 33 zusammengefassten Feldfacetten 22 werden von zwei in x-Richtung verlaufenden und in y-Richtung übereinander liegenden Reihen der Einzelspiegel- Teilbündel 31 praktisch vollständig ausgeleuchtet. Der Überlappungsgrad dieser Ausleuchtung mit den Einzelspiegel-Teilbündeln 31 hat bei dem oberen Block 32 aus zwei Feldfacetten 22 längs der x-Richtung einen anderen Verlauf als bei dem in der Fig. 13 unten dargestellten Block aus zwei Feldfacetten 22. Bei dem oberen Block 32 überlappen die Einzelspiegel-Teilbündel 31 bei mittleren x-Werten längs der Feldfacetten stärker als bei kleinen x-Werten und bei großen x-Werten. Es ergibt sich aufgrund der Abbildung der Feldfacetten 22 des Blocks 32 in das Objektfeld 5 in der x-Richtung, also senkrecht zur Scanrichtung, ein Intensitätsverlauf 34, der in der Figur 13 unten dargestellt ist.

Beim Feldfacettenblock 33 überlappen die Einzelspiegel-Teilbündel 31 bei kleinen x-Werten und bei großen x-Werten stärker als bei mittleren x-Werten. Es ergibt sich über das Objektfeld 5 in der x-Richtung ein Intensitätsverlauf 35, die ebenfalls in der Fig. 13 unten dargestellt ist.

Die beiden Feldfacetten 22 des Feldfacettenblocks 32 werden über zwei diesen Feldfacetten 22 zugeordnete Pupillenfacetten 23a, 23b in das Objektfeld 5 abgebildet. Die beiden Feldfacetten 22 des Feldfacettenblocks 33 werden über zwei weitere Pupillenfacetten 23c, 23d ebenfalls in das Objektfeld 5 abgebildet. Die beiden Pupillenfacetten 23a, 23b einerseits und die beiden Pupillenfacetten 23c, 23d andererseits sind einander jeweils direkt benachbart.

Durch Vorgabe eines entsprechenden Überlappungsgrades der Einzelspiegel-Teilbündel 31 auf den Feldfacetten 22 bzw. den Feldfacetten-Blöcken 32, 33 lässt sich für jeden Ausleuchtungskanal, der definiert ist durch eine der Feldfacetten 22 und die dieser Feldfacette im Beleuchtungslichtstrahlengang hin zum Objektfeld 5 zugeordnete Pupillenfacette 23, eine Abhängigkeit des Intensitätsverlaufes in der x-Richtung (vgl. z.B. Intensitätsverläufe 34, 35 in der Fig. 13) individuell vorgeben. Hierdurch lässt sich diese x-Abhängigkeit an einen Vorgabewert anpassen.

Die Auslegung des Beleuchtungsstrahlengangs kann derart sein, dass Gruppen von mehreren der Einzelspiegel 18, die jeweils auf eine bestimmte der Pupillenfacetten 23 abbildbar sind, auf dem Einzelspiegelarray 17 einander überlappen, sodass bestimmte andere Einzelspiegel 18 mehreren Gruppen angehören, also auf mehrere Pupillenfacetten 23 abbildbar sind. Dies sei nachfolgend anhand der schematischen Fig. 14 näher erläutert. Diese zeigt einen Ausschnitt aus dem Einzelspiegelarray 17 mit den zeilen- und spaltenweise rasterartig angeordneten Einzelspiegeln 18. Innerhalb durch zwei Kreislinien in der Fig. 14 begrenzten Bereichen liegen auf dem Einzelspiegelarray 17 zwei Einzelspiegel-Gruppen 36, 37. Die Einzelspiegel 18 innerhalb der Einzelspiegel-Gruppe 36 sind allesamt auf eine der Pupillenfacetten 23, beispielsweise auf die Pupillenfacette 23a in der Fig. 13, abbildbar. Die Einzelspiegel 18 der Einzelspiegel-Gruppe 37 sind alle auf eine andere der Pupillenfacetten 23, also beispielsweise auf die Pupillenfacette 23b in der Fig. 13, abbildbar. Bestimmte der Einzelspiegel 18, nämlich unter anderem die Einzelspiegel 18_{I} und 18_{II}, gehören beiden dieser Gruppen 36, 37 an. Die Einzelspiegel 18_{I} und 18_{II} sind also wahlweise auf die Pupillenfacette 23a oder auf die Pupillenfacette 23b abbildbar. Die Feldfacetten 22 oder die Feldfacettenblöcke 32, 33, die diese Abbildung bewerkstelligen, können einander benachbart sein. In diesem Fall können die Einzelspiegel 18_{I} und 18_{II} zur Ausleuchtung auf eine zwischen den benachbarten Feldfacetten vorliegende Grenze gerichtet sein, da unabhängig davon, welche der beiden aneinander angrenzenden Feldfacetten 22 beleuchtet wird, immer eine Abbildung auf eine der beiden gewünschten Pupillenfacetten 23a, 23b erfolgt. In diesem Fall können die Einzelspiegel-Teilbündel 25 auf die Feldfacetten 22 im Bereich der Nachbarschaftsgrenze ohne Einhaltung eines Abstandes zum angrenzenden Feldfacettenrand positioniert werden. Dies erhöht die Systemeffizienz. Je nach Verkippung der Einzelspiegel 18_{I} und 18_{II} lässt sich diejenige Pupillenfacette 23 auswählen, auf die das jeweilige Einzelspiegel-Teilbündel gelenkt wird. Auf diese Weise lässt sich eine Intensitäts-Umverteilung zwischen verschiedenen Pupillenfacetten vornehmen.

Die Einzelspiegel-Teilbündel 25 und die Einzelspiegel-Teilbündel 31, die auch als Ausleuchtungsspots bezeichnet werden, haben auf den Feldfacetten 22 eine Erstreckung längs der kurzen Facettenseite, die größer ist als die kurze Facettenseite. Bei der Beleuchtungssituation nach Fig. 5 ist dieses Erstreckungsverhältnis etwa 3. Bei der Beleuchtungssituation nach Fig. 13 ist das Erstreckungsverhältnis etwa 1,3. Das Erstreckungsverhältnis kann in einem Bereich zwischen 1,1 und 5 liegen.

Die Einzelspiegel-Teilbündel 24, 25 und 31 haben auf den Feldfacetten eine Erstreckung längs der langen Facettenseite, also eine y-Erstreckung, die kleiner ist als die lange Facettenseite. Diese x-Erstreckung der Einzelspiegel-Teilbündel 24, 25, 31 kann z.B. um einen Faktor 2 bis 20 kleiner sein als die x-Erstreckung der Feldfacetten. In der Beleuchtungssituation nach Fig. 3 ist die x-Erstreckung der Einzelspiegel-Teilbündel 24 um etwa einen Faktor 10 kleiner als die x-Erstreckung der Feldfacette 22. In der Beleuchtungssituation nach Fig. 5 ist die x-Erstreckung der Einzelspiegel-Teilbündel 25 um etwa einen Faktor 3 kleiner als die x-Erstreckung der Feldfacetten 22. In der Beleuchtungssituation nach Fig. 13 ist die x-Erstreckung der Einzelspiegel-Teilbündel 31 etwa um einen Faktor 8 kleiner als die x-Erstreckung der Feldfacetten 22.

Fig. 7 verdeutlicht eine Einfallswinkelverteilung des EUV-Strahlungsbündels 14 auf dem Einzelspiegelarray 17. Dargestellt ist das EUV-Strahlungsbündel 14 ab einem Zwischenfokus in der Zwischenfokusebene 16 bis zum Auftreffen auf dem Einzelspiegelarray 17. Die nicht einzeln dargestellten Einzelspiegel des Einzelspiegelarrays 17 in der Anordnung nach Fig. 7 werden unter einem Einfallswinkel beleuchtet, der größer ist als 70 ° und der beispielsweise 85 ° betragen kann. Die Einzelspiegel 18 sind bei der Anordnung nach Figur 7 auf einer gewölbten Grundplatte 38 des Einzelspiegelarray 17 so angebracht, dass in einer Neutralstellung der Einzelspiegel 18 alle Einzelspiegel 18 mit einem innerhalb eines Toleranzbereiches gleichen Einfallswinkel beleuchtet werden. Die Neutralstellung jedes der Einzelspiegel 18 ist dabei eine kräftefreie Stellung des zugehörigen Aktors 19. In der Neutralstellung der Einzelspiegel 18 kann eine gewölbte Gesamtfläche des Einzelspiegelarrays 17 realisiert sein, wie in Fig. 7 dargestellt, es kann aber auch in der Neutralstellung der Einzelspiegel 18 eine plane Grundfläche des Einzelspiegelarrays 17 realisiert sein. Der Toleranzbereich kann beispielsweise bei +/- 1 ° liegen.

Dargestellt sind in der Fig. 7 die beiden Einfallswinkel α₁ und α₂ einerseits des in der Fig. 7 am weitesten links angeordneten Einzelspiegels 18 des Einzelspiegelarrays 17 und andererseits des in der Fig. 7 am weitesten rechts angeordneten Einzelspiegels des Einzelspiegelarrays 17. Es gilt in guter Näherung α₁=α₂=85 °.

Fig. 8 verdeutlicht eine Vorzugsrichtung einer Verkippung der Einzelspiegel 18 des Einzelspiegelarrays 17. Ausgehend von einer Ausgangslage von Reflexionsflächen der Einzelspiegel 18, die angenähert in der xz-Ebene liegt, erfolgt eine Verkippung aufgrund des streifenden Einfalls durch Strahlen 39 des EUV-Strahlungsbündels 14 um eine zur x-Achse parallele Kippachse in der Fig. 8 vorzugsweise entgegen dem Uhrzeigersinn. Die Fig. 8 verdeutlicht dies anhand zweier der Einzelspiegel 18: der in der Fig. 8 ganz rechte Einzelspiegel 18₁ ist um etwa 10 ° gegenüber der Ausgangsstellung, die beispielsweise von den drei in der Fig. 8 links dargestellten Einzelspiegel 18 eingenommen ist, entgegen dem Uhrzeigersinn um eine zur x-Achse parallele Kippachse verkippt. In ihrer Kippstellung wird der Einzelspiegel 18₁ gut von den Strahlen 39 erreicht. Der in der Fig. 8 als dritter Spiegel von rechts dargestellte Einzelspiegel 18₂ ist ausgehend von der Neutralstellung um einen entsprechenden Winkelbetrag um eine zur x-Achse parallele Kippachse im Uhrzeigersinn verkippt. Es wird deutlich, dass aufgrund des streifenden Einfalls ein solcher Kippwinkel nicht zu einer gewünschten Reflexion der Strahlen 39 führt, sodass eine Verkippung der Einzelspiegel 18 in der Darstellung nach Fig. 8 in der Praxis nicht im Uhrzeigersinn erfolgt.

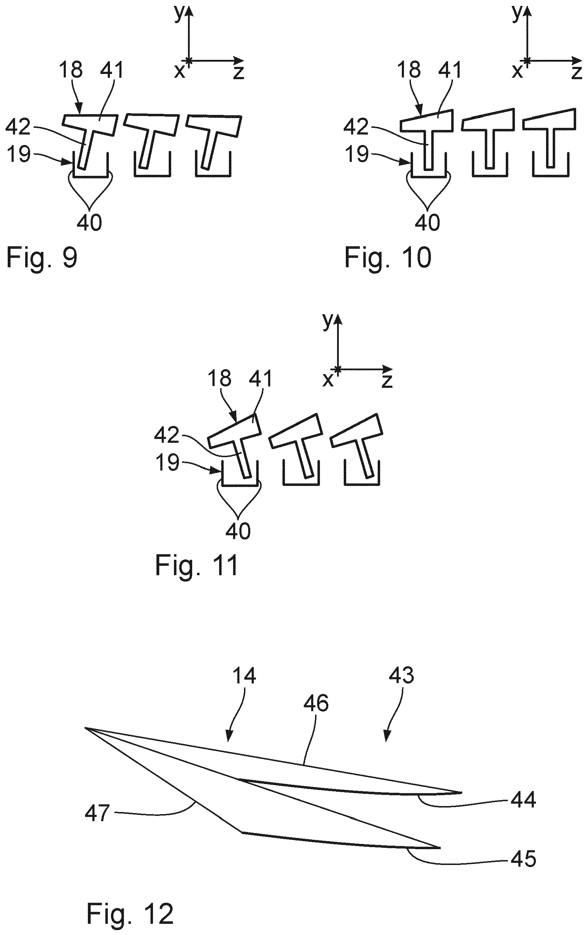

Fig. 9 bis 11 zeigen eine Gruppe von jeweils drei der Einzelspiegel 18 mit zugehörigen Aktoren 19. Die Aktoren 19 sind als elektrostatische Aktoren mit jeweils einem Paar stationärer Elektroden 40 und einem fest mit einem Spiegelkörper 41 des Einzelspiegels 18 verbundenen Elektrodenstift 42 ausgeführt. Fig. 9 zeigt die drei Einzelspiegel 18 in der Neutralstellung, die beispielsweise die drei linken Einzelspiegel 18 in der Fig. 8 ebenfalls einnehmen. In dieser Neutralstellung liegt der Einzelspiegel 18 im Bereich einer der Grenzen des mit dem Aktor 19 erreichbaren Kippbereiches. In der Neutralstellung ist der Elektrodenstift 42 der in der Fig. 9 linken Elektrode 40 nächst benachbart.

Eine gekrümmte Grundfläche des Einzelspiegelarrays 17 kann durch Anordnung der Einzelspiegel 18 auf einer gekrümmten Grundplatte 38 (vgl. Fig. 7) realisiert sein oder kann durch jeweilige Verkippung der Einzelspiegel 18 gegebenenfalls auch dann realisiert sein, wenn das Einzelspiegelarray 17 mit einer planen Grundplatte aufgebaut ist. Weiterhin kann eine gekrümmte Fläche des Einzelspiegelarrays 17 bei einer Maximalverkippung der Einzelspiegel 18 realisiert sein. In dem letzten Fall können die Reflexionsflächen der Einzelspiegel 18 für sich bereits eine Verkippung aufweisen.

Fig. 10 zeigt eine spannungsfreie Situation des Aktors 19. Der Elektrodenstift 42 liegt dabei mittig zwischen den beiden Elektroden 40 des jeweiligen Aktors 19. In dieser Stellung haben die Reflexionsflächen der Einzelspiegel 18 einen Winkel zur xz-Ebene von etwa 5 °.

Fig. 11 zeigt diejenige Stellung der jeweiligen Aktoren 19, bei der jeweils der Elektrodenstift 42 des Aktors 19 der in der Fig. 11 rechts dargestellten Elektrode 40 nächst benachbart ist. In dieser Stellung haben die Reflexionsflächen der Einzelspiegel 18 einen Winkel zur xz-Ebene von 10 °.

Fig. 12 zeigt eine alternative Ausgestaltung eines Einzelspiegelarrays 43, das anstelle des Einzelspiegelarrays 17 der vorstehend beschriebenen Ausführungsformen zum Einsatz kommen kann. Das Einzelspiegelarray 43 wird nachfolgend nur dort beschrieben, wo es sich vom Einzelspiegelarray 17 unterscheidet. Das Einzelspiegelarray 43 ist in mehrere Arrayabschnitte, bei der dargestellten Ausführung in zwei Arrayabschnitte 44, 45 unterteilt. Jeder der Arrayabschnitte 44 ist wie das Einzelspiegelarray 17 aus einer rasterartig zeilen- und spaltenweise angeordneten Vielzahl von Einzelspiegeln aufgebaut. Die beiden Arrayschnitte 44, 45 sind so angeordnet, dass sie jeweils mit einem Beleuchtungs-Teilbündel 46, 47 des gesamten EUV-Strahlungsbündels 14 beleuchtet werden. Auf diese Weise lassen sich auch EUV-Strahlungsbündel 14 mit einer höheren numerischen Apertur vom Einzelspiegelarray 43 vollständig weiterleiten. Die Arrayabschnitte 44, 45 des Einzelspiegelarrays 43 können als Ringschalen aufgebaut sein, wie dies von der Grundform her von sogenannten genesteten Kollektoren her für Kollektoren bekannt sind, die anstelle des Kollektors 15 zum Einsatz kommen. Es können die typischen Wolter-Geometrien derartiger genesteter Spiegel-Aufbauten genutzt werden.

Diese Vorgabe der Intensitätsverteilung bzw. des Intensitätsverlaufs in der x-Richtung des Objektfeldes 5 kann genutzt werden, eine Uniformität der Objektfeldausleuchtung ohne Lichtverlust zu korrigieren. Es können auch gezielt vom jeweiligen Feldort in der x-Richtung, also von der jeweiligen Feldhöhe, abhängige Beleuchtungswinkelverteilungen vorgegeben werden.

Die Feldfacetten des Feldfacettenspiegels können in nicht zusammenhängenden Bereichen angeordnet sein, zwischen denen Zwischenräume vorliegen. Eine solche Ausführung des Feldfacettenspiegels ist in der Zeichnung nicht dargestellt. Die Zwischenräume können beispielsweise dort vorliegen, wo das Beleuchtungslicht am Ort des Feldfacettenspiegels abgeschattet wird.

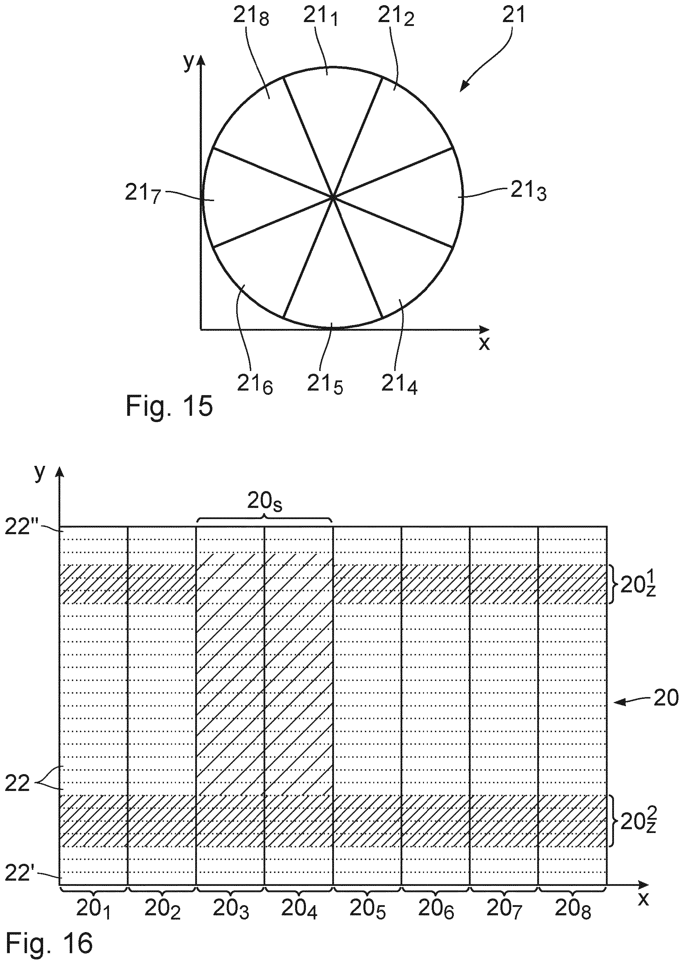

Diejenigen Feldfacetten 22, die die Einzelspiegel 18 des Einzelspiegelarrays 17 auf bestimmte, zusammenhängende Pupillenfacettenbereiche abbilden, können ihrerseits in zusammenhängenden Feldfacettenbereichen angeordnet sein. Dies wird nachfolgend anhand der Fig. 15 und 16 näher erläutert. Komponenten, die denjenigen entsprechen, die vorstehend unter Bezugnahme auf die Figuren 1 bis 14 bereits erläutert wurden, tragen die gleichen Bezugsziffern und werden nicht nochmals im Einzelnen diskutiert.

Fig. 15 zeigt eine Aufsicht auf eine Ausführung des Pupillenfacettenspiegels 21, der in insgesamt acht sektorförmige, zusammenhängende Pupillenfacettenbereiche 21₁ bis 21₈ unterteilt ist. Zusätzlich können die einzelnen Pupillenfacettenbereiche 21₁ bis 21₈ auch noch radial unterteilt sein, was in der Fig. 15 nicht dargestellt ist. Die Pupillenfacettenbereiche 21ₓ sind in der Fig. 15, beginnend mit dem dort obersten Pupillenfacettenbereich 21₁ mit im Uhrzeigersinn aufsteigendem Index x durchnummeriert. Durch Beleuchtung der vollständigen Sektoren 21₁, 21₅ lässt sich z.B. ein Beleuchtungssetting in Form eines y-Dipols realisieren. Durch vollständige Beleuchtung der Pupillenfacettenbereiche 21₃, 21₇ resultiert entsprechend ein x-Dipol-Beleuchtungssetting.

Innerhalb der Pupillenfacettenbereiche 21₁ bis 21₈ liegt jeweils eine Mehrzahl oder eine Vielzahl der einzelnen Pupillenfacetten 23 vor. Dies ist in der schematischen Fig. 15 nicht dargestellt.

Fig. 16 zeigt ebenfalls in einer Aufsicht eine Ausführung des Feldfacettenspiegels 20 mit zeilen- und spaltenweise angeordneten Feldfacetten 22. Insgesamt hat der Feldfacettenspiegel 20 in der beispielhaften Darstellung nach Fig. 16 acht Spalten mit jeweils 28 Feldfacetten 22, weist also insgesamt 224 Feldfacetten 22 auf. Jede der acht Spalten stellt einen zusammenhängenden Feldfacettenbereich 20₁ bis 20₈ dar. Diese Feldfacettenbereiche 20ₓ sind in der Fig. 16 spaltenweise von links nach rechts mit aufsteigendem Index x versehen.

Die Zuordnung der Feldfacettenbereiche 20₁ bis 20₈ zu den Pupillenfacettenbereichen 21₁ bis 21₈ ist so, dass jeweils der Feldfacettenbereich 20ᵢ Einzelspiegel 18 des Einzelspiegelarrays 17 auf den Pupillenfacettenbereich 21ᵢ abbildet.

Eine Zeilenposition der jeweiligen Feldfacette 22, also der Position der Feldfacette 22 in der y-Richtung nach Fig. 16, ist ein Maß für die radiale Position der zugeordneten Pupillenfacette 23 des dem Feldfacettenbereich 20ᵢ zugeordneten Pupillenfacettenbereichs 21ᵢ. Diese Zuordnung ist bei der Ausführung nach den Fig. 15 und 16 so, dass die Feldfacetten 22 mit aufsteigenden y-Werten innerhalb eines Feldfacettenbereichs 20ᵢ immer größere Radien innerhalb des sektorförmigen Pupillenfacettenbereichs 21ᵢ beleuchten. Eine dem kleinsten y-Wert zugeordnete Feldfacette 22' im Feldfacettenbereich 22₁ (vergleiche Fig. 16) beleuchtet dementsprechend eine Pupillenfacette 23, die im Pupillenfacettenbereich 21₁ nahe dem Zentrum des Pupillenfacettenspiegels 21, also bei minimalem Radius um das Zentrum, liegt. Entsprechend beleuchtet eine dem größten y-Wert zugeordnete Feldfacette 22" im Feldfacettenbereich 20₁ eine im Pupillenfacettenbereich 21₁ radial ganz außen liegende Pupillenfacette 23.

Mit der gewählten Zuordnung der Feldfacettenbereiche 20₁ zu den Pupillenfacettenbereichen 21ᵢ lassen sich beispielsweise auch annulare Beleuchtungssettings realisieren. Dies ist in den in Fig. 16 durch Schraffur hervorgehobenen Facetten-Zeilenbereichen 20_{z}¹ und 20_{z}² veranschaulicht. Sofern sämtliche Feldfacetten 22 innerhalb des Feldfacetten-Zeilenbereichs 20_{z}¹ beleuchtet werden, resultiert eine ringförmige Beleuchtung in einem radial äußeren Bereich aller Pupillenfacettenbereiche 21₁ bis 21₈ und ein entsprechendes annulares Beleuchtungssetting mit relativ großem Beleuchtungswinkel. Wenn der Zeilen-Feldfacettenbereich 20_{z}² über alle Feldfacettenbereiche 20₁ bis 20₈ beleuchtet wird, resultiert eine Beleuchtung aller Pupillenfacettenbereiche 21₁ bis 21₈ in einem radial innen liegenden Bereich und entsprechend ein annulares Beleuchtungssetting mit relativ kleinem Beleuchtungswinkel.

Wenn beispielsweise die Feldfacettenbereiche 20₁ und 20₅ beleuchtet werden, resultiert eine Beleuchtung der Pupillenfacettenbereiche 21₁, 21₅ und damit das schon vorstehend angesprochene x-Dipol-Beleuchtungssetting. Beispielhaft ist in der Fig. 16 eine im Vergleich zu den beiden Feldfacetten-Zeilenbereichen 20_{z}¹ , 20_{z}² durch weiter voneinander beabstandeten Schraffurlinien angedeutete Ausleuchtung eines Feldfacetten-Spaltenbereichs 20ₛ dargestellt, der einen Großteil der Feldfacettenbereiche 20₃, 20₄ umfasst. Eine Beleuchtung des Feldfacetten-Spaltenbereichs 20ₛ würde zu einer Beleuchtung der Pupillenfacettenbereiche 21₃ und 21₄ führen, also zu einer Pupillenausleuchtung mit einem Schwerpunkt im IV. Quadranten des Pupillenfacettenspiegels 21.

Durch entsprechende Zusammenfassung von Feldfacetten 22 aus den Feldfacettenbereichen 20₁ bis 20₈ können auch andere Beleuchtungssettings, beispielsweise Multipol-Beleuchtungssettings oder konventionelle Beleuchtungssetting mit vorgegebenem maximalem Beleuchtungswinkel realisiert werden. Die Feldfacettenbereiche 20₁ bis 20₈ werden auch als Makroblöcke bezeichnet.

Generell gilt bei der Zuordnung der Feldfacettenbereiche 20ᵢ zu den Pupillenfacettenbereichen 21ᵢ, dass eine Anordnung gewählt wird, bei der die Feldfacetten 22, die innerhalb eines der Feldfacettenbereiche 22ᵢ nebeneinander liegen, auch möglichst dicht beieinander liegenden Pupillenfacetten 23 zugeordnet werden. Auch eine Zuordnung nebeneinander liegender Feldfacetten 22 zu punktsymmetrisch angeordneten Pupillenfacetten 23 ist möglich. Generell gilt bei der Zuordnung der Feldfacettenbereiche 20ᵢ zu den Pupillenfacettenbereichen 21ᵢ, die jeweils auch als Mikroblöcke bezeichnet werden, dass die Lage und/oder die Anordnung der Facettenbereiche berücksichtigt werden muss, wenn die Beleuchtungsoptik 4 hinsichtlich ihrer Systemeffizienz bzw. hinsichtlich ihrer Reflexionseffizienz optimiert wird.

Bei der Projektionsbelichtung werden das Retikel 7 und der Wafer 12, der eine für das EUV-Strahlungsbündel 14 lichtempfindliche Beschichtung trägt, bereitgestellt. Anschließend wird zumindest ein Abschnitt des Retikels 7 auf den Wafer 12 mit Hilfe Projektionsbelichtungsanlage 1 projiziert. Schließlich wird die mit dem EUV-Strahlungsbündel 14 belichtete lichtempfindliche Schicht auf dem Wafer 12 entwickelt. Auf diese Weise wird das mikro- bzw. nanostrukturierte Bauteil, beispielsweise ein Halbleiter, hergestellt.

## Patentansprüche

1. Beleuchtungsoptik (4) für die Projektionslithographie zur Ausleuchtung eines Objektfeldes (5), in dem ein abzubildendes Objekt (7) anordenbar ist, mit Beleuchtungslicht,
- mit einem Feldfacettenspiegel (20) mit einer Mehrzahl von Feldfacetten (22),
- mit einem Pupillenfacettenspiegel (21) mit einer Mehrzahl von Pupillenfacetten (23),
- wobei die Pupillenfacetten (23) zur Abbildung der jeweils den Pupillenfacetten (23) individuell zugeordneten Feldfacetten (22) in das Objektfeld (5) dienen,
- mit einem Einzelspiegelarray (17) mit individuell angesteuert verkippbaren Einzelspiegeln (18), das in einem Beleuchtungslicht-Strahlengang vor dem Feldfacettenspiegel (20) angeordnet ist,
- wobei die Einzelspiegel (18) derart angeordnet sind, dass die Feldfacetten (22) die Einzelspiegel (18) des Einzelspiegelarrays (17) auf zugeordnete Pupillenfacetten (23) abbilden.

2. Beleuchtungsoptik nach Anspruch 1, **gekennzeichnet durch** eine Anordnung derart, dass jeweils eine Gruppe von mehreren Einzelspiegeln (18) auf eine der Pupillenfacetten (23) abgebildet wird.

3. Beleuchtungsoptik nach Anspruch 1, **gekennzeichnet durch** eine Anordnung derart, dass jeweils eine Gruppe von mehreren Einzelspiegeln (18) die auf eine der Pupillenfacetten (23) abbildbar ist, durch Verkippung von mindestens einigen der Einzelspiegel (18) der Gruppe auf eine Mehrzahl von Pupillenfacetten (23) abgebildet wird.

4. Beleuchtungsoptik nach einem der Ansprüche 1 bis 3, **gekennzeichnet durch** eine Auslegung des Beleuchtungsstrahlengangs derart, dass Einzelspiegel-Teilbündel (24; 25; 31) individueller Einzelspiegel (18) auf dem Feldfacettenspiegel (20) überlappen.

5. Beleuchtungsoptik nach einem der Ansprüchen 1 bis 4, **gekennzeichnet durch** eine Auslegung des Beleuchtungsstrahlengangs derart, dass Gruppen (36, 37) von mehreren Einzelspiegeln (18), die jeweils auf eine bestimmte Pupillenfacette (23) abbildbar sind, auf dem Einzelspiegelarray (17) einander überlappen, sodass das bestimmte Einzelspiegel (18_{I}, 18_{II}) mehreren Gruppen (36, 37) gleichzeitig angehören, also auf mehrere Pupillenfacetten (23) abbildbar sind.

6. Beleuchtungsoptik nach einem der Ansprüche 1 bis 5, **dadurch gekennzeichnet, dass** die Feldfacetten (22) ein Aspektverhältnis größer als 1, also eine lange Facettenseite und eine kurze Facettenseite, haben, mit einer Auslegung des Beleuchtungsstrahlengangs derart, dass Einzelspiegel-Teilbündel (25; 31) individueller Einzelspiegel (18) auf dem Feldfacettenspiegel (20) eine Erstreckung längs der kurzen Facettenseite haben, die größer ist als die kurze Facettenseite.

7. Beleuchtungsoptik nach einem der Ansprüche 1 bis 6, **dadurch gekennzeichnet, dass** die Feldfacetten (22) ein Aspektverhältnis größer als 1, also eine lange Facettenseite und eine kurze Facettenseite haben, mit einer Auslegung des Beleuchtungsstrahlengangs derart, dass Einzelspiegel-Teilbündel (24; 25; 31) individueller Einzelspiegel (18) auf dem Feldfacettenspiegel (20) eine Erstreckung längs der langen Facettenseite haben, die kleiner ist als die lange Facettenseite.

8. Beleuchtungsoptik nach einem der Ansprüche 1 bis 7, **gekennzeichnet durch** eine Anordnung derart, dass die Einzelspiegel (18) unter einem Einfallswinkel (α) beleuchtet werden, der größer ist als 65 °.

9. Beleuchtungsoptik nach einem der Ansprüche 1 bis 8, **dadurch gekennzeichnet, dass** die Einzelspiegel (18) auf einer gewölbten Grundplatte (38) durch das Einzelspiegelarray (17) derart angebracht sind, dass in einer Neutralstellung der Einzelspiegel (18) alle Einzelspiegel (18) mit einem innerhalb eines Toleranzbereiches gleichen Einfallswinkel (α) beleuchtet werden.

10. Beleuchtungsoptik nach Anspruch 9, **dadurch gekennzeichnet, dass** die Einzelspiegel (18) einen ansteuerbaren Kippbereich haben, wobei ein Kippaktor (19) jeweils eines der Einzelspiegel (18) so ausgeführt ist, dass der gesamte Kippbereich durch elektrostatische Anziehungskraft zwischen Elektroden (40, 42) des Kippaktors (19) erreicht wird, wobei der Einzelspiegel (18) in der Neutralstellung im Bereich eines der Ränder des elektrostatisch erreichbaren Kippbereiches liegt.

11. Beleuchtungsoptik nach einem der Ansprüche 1 bis 10, **dadurch gekennzeichnet, dass** das Einzelspiegelarray (17) in mehrere, voneinander separate Abschnitte (44, 45) unterteilt ist, die so angeordnet sind, dass sie jeweils mit einem Teil (46, 47) eines gesamten Strahlungsbündels (14) beleuchtbar sind.

12. Beleuchtungsoptik nach einem der Ansprüche 1 bis 11, **dadurch gekennzeichnet, dass** diejenigen Feldfacetten (22), die Einzelspiegel (18) des Einzelspiegelarrays (17) auf bestimmte, zusammenhängende Pupillenfacettenbereiche (21₁ bis 21₈) abbilden, in zusammenhängenden Feldfacettenbereichen (20₁ bis 20₈) angeordnet sind.

13. Beleuchtungssystem mit einer Beleuchtungsoptik (4) nach Anspruch 12 und mit einer Projektionsoptik (9) zur Abbildung des Objektfeldes (5) in ein Bildfeld (10), in dem ein zu belichtender Wafer (12) anordenbar ist.

14. Projektionsbelichtungsanlage mit einem Beleuchtungssystem nach Anspruch 13 und mit einer Strahlungsquelle (3) für das Strahlungsbündel (14).

15. Verfahren zur Herstellung strukturierter Bauelemente mit folgenden Schritten:
- Bereitstellen eines Wafers (12), auf den zumindest teilweise eine Schicht aus einem lichtempfindlichen Material aufgebracht ist,
- Bereitstellen eines Retikels (7), das abzubildende Strukturen aufweist,
- Bereitstellen einer Projektionsbelichtungsanlage (1) nach Anspruch 14,
- Projizieren wenigstens eines Teils des Retikels (7) auf einen Bereich der Schicht des Wafers (12) mit Hilfe der Projektionsbelichtungsanlage (1).

## Claims

1. Illumination optical unit (4) for projection lithography for illuminating an object field (5), in which an object (7) to be imaged can be arranged, with illumination light,
- comprising a field facet mirror (20) having a plurality of field facets (22),
- comprising a pupil facet mirror (21) having a plurality of pupil facets (23),
- wherein the pupil facets (23) serve for imaging the field facets (22) respectively assigned individually to the pupil facets (23) into the object field (5),
- having an individual mirror array (17) having individual mirrors (18) that can be tilted in driven fashion individually, said array being arranged in an illumination light beam path upstream of the field facet mirror (20),
- wherein the individual mirrors (18) are arranged such that the field facets (22) image the individual mirrors (18) of the individual mirror array (17) onto assigned pupil facets (23).

2. Illumination optical unit according to Claim 1, **characterized by** an arrangement in such a way that in each case a group of a plurality of individual mirrors (18) is imaged onto one of the pupil facets (23).

3. Illumination optical unit according to Claim 1, **characterized by** an arrangement in such a way that in each case a group of a plurality of individual mirrors (18) which can be imaged onto one of the pupil facets (23) is imaged onto a plurality of pupil facets (23) by the tilting of at least some of the individual mirrors (18) of the group.

4. Illumination optical unit according to any of Claims 1 to 3, **characterized by** a design of the illumination beam path in such a way that individual mirror partial beams (24; 25; 31) of specific individual mirrors (18) overlap on the field facet mirror (20).

5. Illumination optical unit according to any of Claims 1 to 4, **characterized by** a design of the illumination beam path in such a way that groups (36, 37) of a plurality of individual mirrors (18) which can in each case be imaged onto a specific pupil facet (23) overlap one another on the individual mirror array (17), such that specific individual mirrors (18_{I}, 18_{II}) belong to a plurality of groups (36, 37) simultaneously, that is to say can be imaged onto a plurality of pupil facets (23).

6. Illumination optical unit according to any of Claims 1 to 5, **characterized in that** the field facets (22) have an aspect ratio of greater than 1, that is to say a long facet side and a short facet side, with a design of the illumination beam path in such a way that individual mirror partial beams (25; 31) of specific individual mirrors (18) have on the field facet mirror (20) an extent along the short facet side that is larger than the short facet side.

7. Illumination optical unit according to any of Claims 1 to 6, **characterized in that** the field facets (22) have an aspect ratio of greater than 1, that is to say a long facet side and a short facet side, with a design of the illumination beam path in such a way that individual mirror partial beams (24; 25; 31) of specific individual mirrors (18) have on the field facet mirror (20) an extent along the long facet side that is smaller than the long facet side.

8. Illumination optical unit according to any of Claims 1 to 7, **characterized by** an arrangement in such a way that the individual mirrors (18) are illuminated at an angle (α) of incidence that is greater than 65 °.

9. Illumination optical unit according to any of Claims 1 to 8, **characterized in that** the individual mirrors (18) are fitted on a curved baseplate (38) through the individual mirror array (17) in such a way that, in a neutral position of the individual mirrors (18), all of the individual mirrors (18) are illuminated with an angle (α) of incidence that is identical within a tolerance range.

10. Illumination optical unit according to Claim 9, **characterized in that** the individual mirrors (18) have a drivable tilting range, wherein a tilting actuator (19) of one of the individual mirrors (18) in each case is embodied such that the entire tilting range is attained by electrostatic attractive force between electrodes (40, 42) of the tilting actuator (19), wherein the individual mirror (18), in the neutral position, lies in the region of one of the edges of the electrostatically attainable tilting range.

11. Illumination optical unit according to any of Claims 1 to 10, **characterized in that** the individual mirror array (17) is subdivided into a plurality of mutually separate sections (44, 45) arranged such that they can be illuminated in each case with part (46, 47) of an entire radiation beam (14).

12. Illumination optical unit according to any of Claims 1 to 11, **characterized in that** those field facets (22) which image individual mirrors (18) of the individual mirror array (17) onto specific, continuous pupil facet regions (21₁ to 21₈) are arranged in continuous field facet regions (20₁ to 20₈) .

13. Illumination system comprising an illumination optical unit (4) according to Claim 12 and comprising a projection optical unit (9) for imaging the object field (5) into an image field (10), in which a wafer (12) to be exposed can be arranged.

14. Projection exposure apparatus comprising an illumination system according to Claim 13 and comprising a radiation source (3) for the radiation beam (14).

15. Method for producing patterned components comprising the following steps:
- providing a wafer (12), to which a layer composed of a light-sensitive material is at least partly applied,
- providing a reticle (7) having structures to be imaged,
- providing a projection exposure apparatus (1) according to Claim 14,
- projecting at least part of the reticle (7) onto a region of the layer of the wafer (12) with the aid of the projection exposure apparatus (1).

## Revendications

1. Optique d'éclairage (4) pour la lithographie par projection, destinée à éclairer avec de la lumière d'éclairage un champ d'objet (5) dans lequel peut être disposé un objet (7) à représenter,
- comprenant un miroir à facettes de champ (20) doté d'une pluralité de facettes de champ (22),
- comprenant un miroir à facettes de pupille (21) doté d'une pluralité de facettes de pupille (23),
- les facettes de pupille (23) servant à représenter dans le champ d'objet (5) les facettes de champ (22) respectivement associées individuellement aux facettes de pupille (23),
- comprenant un réseau de miroirs uniques (17) doté de miroirs uniques (18) pouvant basculer commandés individuellement, lequel est disposé devant le miroir à facettes de champ (20) dans un trajet de rayon d'éclairage,
- les miroirs uniques (18) étant disposés de telle sorte que les facettes de champ (22) représentent les miroirs uniques (18) du réseau de miroirs uniques (17) sur des facettes de pupille (23) associées.

2. Optique d'éclairage selon la revendication 1, **caractérisée par** un arrangement tel qu'un groupe de plusieurs miroirs uniques (18) est respectivement représenté sur l'une des facettes de pupille (23).

3. Optique d'éclairage selon la revendication 1, **caractérisée par** un arrangement tel qu'un groupe de plusieurs miroirs uniques (18) qui peut être représenté sur l'une des facettes de pupille (23) est représenté respectivement sur une pluralité de facettes de pupille (23) par basculement d'au moins certains des miroirs uniques (18) du groupe.

4. Optique d'éclairage selon l'une des revendications 1 à 3, **caractérisée par** une conception du trajet de rayon d'éclairage telle que des faisceaux partiels de miroir unique (24 ; 25 ; 31) des miroirs uniques (18) individuels se chevauchent sur le miroir à facettes de champ (20).

5. Optique d'éclairage selon l'une des revendications 1 à 4, **caractérisée par** une conception du trajet de rayon d'éclairage telle que des groupes (36, 37) de plusieurs miroirs uniques (18) qui peuvent respectivement être représentés sur une facette de pupille (23) donnée se chevauchent mutuellement sur le réseau de miroirs uniques (17), de sorte que certains miroirs uniques (18_{I}, 18_{II}) appartiennent simultanément à plusieurs groupes (36, 37), c'est-à-dire peuvent être représentés sur plusieurs facettes de pupille (23).

6. Optique d'éclairage selon l'une des revendications 1 à 5, **caractérisée en ce que** les facettes de champ (22) possèdent un rapport d'aspect supérieur à 1, c'est-à-dire un côté de facette long et un côté de facette court, avec une conception du trajet de rayon d'éclairage telle que des faisceaux partiels de miroir unique (25 ; 31) des miroirs uniques (18) individuels possèdent sur le miroir à facettes de champ (20) une projection le long du côté de facette court qui est plus grande que le côté de facette court.

7. Optique d'éclairage selon l'une des revendications 1 à 6, **caractérisée en ce que** les facettes de champ (22) possèdent un rapport d'aspect supérieur à 1, c'est-à-dire un côté de facette long et un côté de facette court, avec une conception du trajet de rayon d'éclairage telle que des faisceaux partiels de miroir unique (24 ; 25 ; 31) des miroirs uniques (18) individuels possèdent sur le miroir à facettes de champ (20) une projection le long du côté de facette long qui est plus petite que le côté de facette long.

8. Optique d'éclairage selon l'une des revendications 1 à 7, **caractérisée par** un arrangement tel que les miroirs uniques (18) sont éclairés sous un angle d'incidence (α) qui est supérieur à 65°.

9. Optique d'éclairage selon l'une des revendications 1 à 8, **caractérisée en ce que** les miroirs uniques (18) sont montés sur une plaque de base (38) cintrée par le réseau de miroirs uniques (17) de telle sorte que dans une position neutre des miroirs uniques (18) tous les miroirs uniques (18) sont éclairés avec un angle d'incidence (α) identique au sein d'une plage de tolérances.

10. Optique d'éclairage selon la revendication 9, **caractérisée en ce que** les miroirs uniques (18) possèdent une plage de basculement commandable, un actionneur de basculement (19) respectif de l'un des miroirs uniques (18) étant exécuté de telle sorte que la plage de basculement totale est atteinte par une force d'attraction électrostatique entre des électrodes (40, 42) de l'actionneur de basculement (19), le miroir unique (18) dans la position neutre se trouvant dans la zone de l'un des bords de la plage de basculement pouvant être atteinte par effet électrostatique.

11. Optique d'éclairage selon l'une des revendications 1 à 10, **caractérisée en ce que** le réseau de miroirs uniques (17) est subdivisé en plusieurs portions (44, 45) séparées les unes des autres, lesquelles sont disposées de telle sorte qu'elles peuvent respectivement être éclairées par une partie (46, 47) d'un faisceau de rayonnement (14) global.

12. Optique d'éclairage selon l'une des revendications 1 à 11, **caractérisée en ce que** les facettes de champ (22) qui représentent des miroirs uniques (18) du réseau de miroirs uniques (17) sur des zones de facettes de pupille (21₁ à 21₈) définies contiguës sont disposées dans des zones de facettes de champ (20₁ à 20₈) contiguës.

13. Système d'éclairage comprenant une optique d'éclairage (4) selon la revendication 12 et comprenant une optique de projection (9) destinée à représenter le champ d'objet (5) dans un champ d'image (10) dans lequel peut être disposée une galette (12) à éclairer.

14. Équipement d'éclairage par projection comprenant un système d'éclairage selon la revendication 13 et comprenant une source de rayonnement (3) pour le faisceau de rayonnement (14).

15. Procédé de fabrication de composants structurés, comprenant les étapes suivantes :
- fourniture d'une galette (12) sur laquelle est appliquée au moins partiellement une couche en un matériau photosensible,
- fourniture d'un réticule (7) qui possède des structures à représenter,
- fourniture d'un équipement d'éclairage par projection (1) selon la revendication 14,
- projection d'au moins une partie du réticule (7) sur une zone de la couche de la galette (12) à l'aide de l'équipement d'éclairage par projection (1).
